Europäisches Patentamt

European Patent Office

Office européen des brevets

(19)

(11) Publication number:  **0 197 708**
**A2**

(12)

# EUROPEAN PATENT APPLICATION

(21) Application number: **86302239.8**

(22) Date of filing: **26.03.86**

(51) Int. Cl.⁴: **H 03 D 3/00**

(30) Priority: **03.04.85 GB 8508714**

(43) Date of publication of application:
**15.10.86 Bulletin 86/42**

(84) Designated Contracting States:
**AT BE CH DE FR IT LI LU NL SE**

(71) Applicant: **STC PLC**
**190 Strand**
**London, WC2R 1DU(GB)**

(72) Inventor: **Wong, Andrew Chi-Chung**
**49 Copse Hill**
**Harlow Essex(GB)**

(72) Inventor: **Rolley, Robert**
**13 Vicarage Road**
**Ware Hertfordshire, SG1 2BG(GB)**

(74) Representative: **Capsey, Sydney Ross et al,**
**Standard Telephones and Cables Patent Department**
**Edinburgh Way**
**Harlow Essex CM20 2SH(GB)**

(54) **Digital zero IF circuit.**

(57) A digital zero IF circuit having first and second signal paths 11I, 11Q to which a radio frequency signal is applied, each path including a sampling and digitising means 12I, 12Q and a digital filter means 13I, 13Q, the circuit including a clock generator arranged to generate two clock pulse trains in quadrature phase relationship, each sampling means being operated in response to a respective one of the clock pulse trains.

Croydon Printing Company Ltd

## DIGITAL ZERO IF CIRCUIT

This invention relates to a digital zero IF circuit for use in, inter alia, radio or radar receivers.

The zero IF direct conversion or homodyne principle is well known. A received modulated carrier is mixed with a local oscillator signal at the carrier frequency to produce quadrature components of the modulation at baseband. These quadrature components can then be demodulated by suitable processing at baseband frequencies. For example, in British patent No. 1,530,602 there is disclosed a zero IF radio receiver in which the differential of each quadrature signal channel is multiplied by the undifferentiated signal of the other channel and one of the resulting products is subtracted from the other. This arrangement will demodulate an audio frequency modulated radio signal. Another demodulation arrangement is disclosed in British patent No. 1,517,121 this time for a binary digital phase shift modulated radio signal such as is used in the POCSAG radiopaging system operated by British Telecom. The quadrature channel signals are each amplified and hard limited to form square waves which are applied as input and clock respectively to a clocked bistable device. The output of the bistable device is a two state d.c. logic signal indicative of the binary modulation of the input signal.

According to the present invention there is provided a digital zero IF circuit having first and second signal paths to which a radio frequency signal is applied, each path including a sampling and digitising means and a digital filter means, the circuit including a clock generator arranged to generate two clock pulse trains in quadrature phase relationship, each sampling means being operated in response to a respective one of the clock pulse trains, each clock pulse train running at a frequency of $2f_c$, where $f_c$ is the r.f. carrier frequency.

The invention further provides a method of digitally processing a radio frequency signal including the steps of applying the signal to identical first and second signal paths and, in each signal path, sampling the signal, digitising the sampled signal and digitally filtering the digitised signal, the sampling of the signal in the two paths being effected under the control of respective clock pulse trains both of the same frequency but having a quadrature phase relationship, where $f_c$ is the r.f. carrier frequency.

Embodiments of the invention will now be described with reference to the accompanying drawings, in which:-

Fig. 1 illustrates a general case of a digital zero IF circuit according to the invention, and

Fig. 2 illustrates a particular implementation of a digital zero IF circuit.

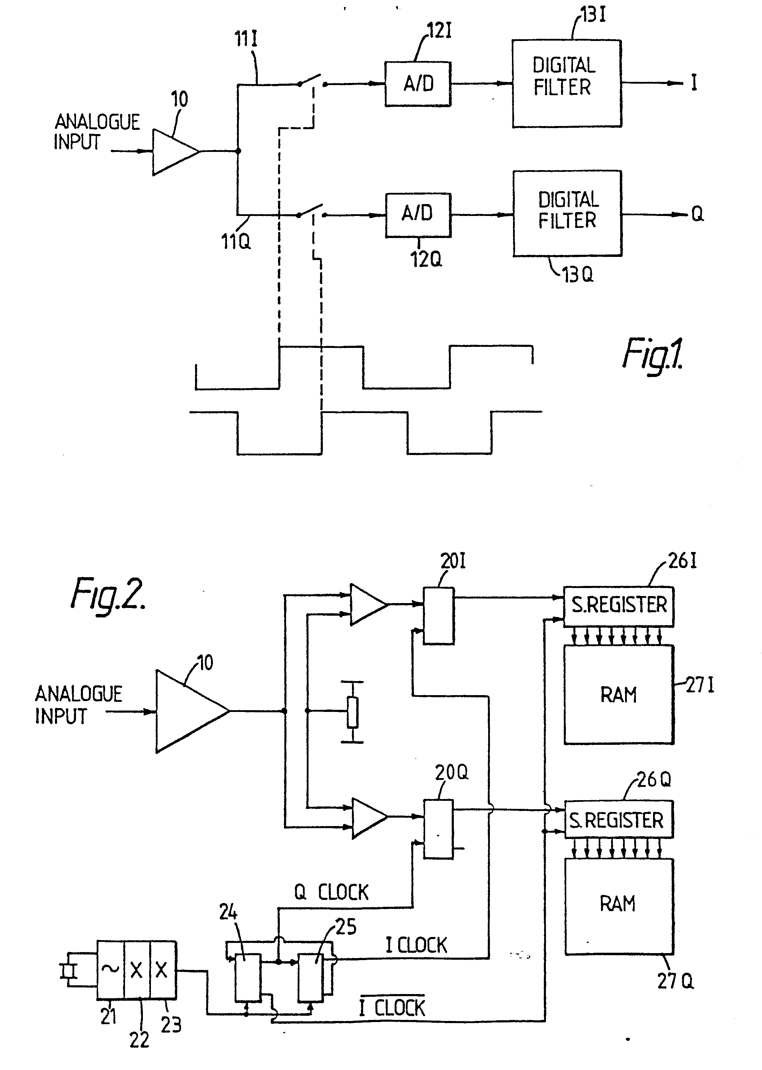

Referring to the general case shown in Fig. 1, a modulated r.f. signal is received and amplified in amplifier 10. The amplifier r.f. signal then fed to two identical signal paths 11I, 11Q. In each path the signal is sampled and digitised by an analogue-to-digital converter 12I, 12Q. The digitised signal is then passed through a digital filter arrangement 13I, 13Q. Sampling of the analogue signal is controlled by two clock pulse trains in quadrature running at a frequency 2fc, where fc is the carrier frequency of the input signal. Thus the
baseband content of the input signal is extracted in the
form of two phase quadrature components (I & Q). Because
all the signal processing is performed in digital
circuitry the balance between the I & Q channels is
maintained. Quadrature orthogonality is maintained
throughout a wide range of frequencies fc, being a
function of the clock pulse orthogonality which is
relatively easy to achieve. There is also a high
uniformity of channel bandwidths.

In the preferred embodiment shown in Fig. 2, the
sampling and digitising is accomplished by using fast
analogue-to-digital converters 20I, 20Q producing a
digital data stream for each of the quadrature channels.
Depending on the circuit requirement, the A/D converters
can be as low as 1-bit, in which case the encoders are
not necessary, and only one single pair of comparators
are required, or alternatively, n pairs of comparators
can be employed to give a $\log_e$n-bit A/D converter with
consequential increase in circuit complexity. The A/D
converters 20I, 20Q are driven by I & Q clocks derived
from a clock signal generator consisting of a crystal
controlled oscillator 21 the output of which is
multiplied (22, 23) and fed to a two stage Johnson
counter (24, 25). An output from one stage of the
counter forms the I clock and a corresponding output from
the other stage forms the Q clock. A further output is
taken from an appropriate stage of the counter to provide
a shift register clock, typically this is the I clock.
The digitised I and Q data streams are fed into serial
shift registers 26I, 26Q. The contents of the shift
register are transferred in parallel once each bit period
to form an address word for a random access memory (RAM)
27I, 27Q. The RAMs are loaded with look-up tables
whereby the addressed RAMs function as digital filters.
The outputs of the RAMs can then be used as digital I and
Q words with further increase in word-resolution (by

0197708

virtue of the integration in the digital filter). The advantages of the arrangement shown in Fig. 2 are

a)   instant programmability of bandwidth,

b)   ideal for front end processing, because of its circuit property of high throughput, at low resolution.

c)   ready alteration of frequency, by modification of clock generator,

d)   amenable to monolithic implementation, by virtue of circuit simplicity.

0197708

CLAIMS:-

1. A digital zero IF circuit having first and second signal paths (11I, 11Q) to which a radio frequency signal is applied, characterised in that each path includes a sampling and digitising means (12I, 12Q) and a digital filter means (13I, 13Q), the circuit including a clock generator arranged to generate two clock pulse trains in quadrature phase relationship, each sampling means being operated in response to a respective one of the clock pulse trains, each clock pulse train running at a frequency of $2f_c$, where $f_c$ is the r.f. carrier frequency..

2. A digitial zero IF circuit according to claim 1 characterised in that each digital filter means comprises a shift register (26I, 26Q) into which the digitised signals are fed and a memory (27I, 27Q) containing look-up tables, the contents of the shift register forming a parallel address for the memory.

3. A digital zero IF circuit according to claim 1 or 2 characterised in that each digitising means (20I, 20Q) comprises in the simplest case of a 1-bit analogue to digital converter.

4. A digital zero IF circuit according to claim 1 or 2 characterised in that each digitising means (20I, 20Q) comprises a zero crossing detector.

5. A digital zero IF circuit according to claim 1 or 2 characterised in that each digitising means comprises a number of zero-crossing detectors operating in parallel followed by an n bit to $\log_e n$ bit encoder to obtain a multiple-bit output.

6. A method of digitally processing a radio frequency signal including the steps of applying the signal to identical first and second signal paths and, in each signal path, sampling the signal, digitising the sampled signal and digitally filtering the digitised signal, the sampling of the signal in the two paths being effected under the control of respective clock pulse trains both of the same frequency $2f_c$ but having a quadrature phase relationship, where $f_c$ is the r.f. carrier frequency.

**0197708**

Fig.1.

Fig.2.